# EUROPEAN PATENT APPLICATION

(11) **EP 4 800 373 A1**
(43) Date of publication of application: **02.09.2026**
(21) Application number: 24890200.9
(22) Date of filing: 02.08.2024
(51) Int. Cl.: G01N 21/25, H01M 10/48, H01M 10/058, H01M 10/052, G01R 31/00, G01R 31/36, H01M 10/0525

(54) **LITHIUM PLATING EVALUATION METHOD FOR BATTERY BASED ON FIBER-OPTIC SENSOR, AND DEVICE THEREOF**

(30) Priority: 16.11.2023 CN 202311529776
(71) Applicant: Contemporary Amperex Technology Co., Limited, Ningde, Fujian 352100 (CN)
(72) Inventor: WU, Kai, Ningde, Fujian 352100 (CN); SUN, Long, Ningde, Fujian 352100 (CN); XIE, Lan, Ningde, Fujian 352100 (CN); CHEN, Zhishan, Ningde, Fujian 352100 (CN); ZHU, Cuicui, Ningde, Fujian 352100 (CN); LIN, Zhen, Ningde, Fujian 352100 (CN); LI, Wei, Ningde, Fujian 352100 (CN)
(74) Representative: Kraus & Lederer PartGmbB
(86) International application number: PCT/CN2024/109595
(87) International publication number: WO 2025/102836

(57) **Abstract**

Disclosed in the present application are a lithium plating evaluation method for a battery based on a fiber-optic sensor, and a device thereof, wherein the device comprises a battery, a battery system, and an electrical apparatus. The lithium plating evaluation method comprises: obtaining a first optical signal output by a fiber-optic sensor when a battery is being charged; obtaining a first spectral signal corresponding to the first optical signal, and obtaining a total enveloped area of a cladding region of the first spectral signal when the battery is being charged on the basis of the first spectral signal; obtaining a second spectral envelope area corresponding to internal stress when the battery is being charged; calculating a difference between the total envelope area and the second spectral envelope area, so as to obtain a first spectral envelope area; and determining a lithium plating evaluation result for the battery on the basis of the first spectral envelope area. By means of analysis of a spectral signal, the interference on lithium plating evaluation by the internal stress of a battery can be reduced, the first spectral envelope area corresponding to lithium plating of the battery when the battery is being charged can be quickly obtained, and consequently the lithium plating circumstances inside the battery can be determined.

## Description

The present application claims priority to Chinese Patent Application 2023115297768, filed with the Chinese Patent Office on November 16, 2023 and entitled "LITHIUM PLATING DETECTION METHOD FOR BATTERY BASED ON FIBER-OPTIC SENSOR, AND DEVICE THEREOF", which is incorporated herein by reference in its entirety.

### TECHNICAL FIELD

The present application relates to the technical field of batteries, and particularly relates to a lithium plating detection method for a battery based on a fiber-optic sensor, and a device thereof; and the device includes a battery, a battery system, and an electrical apparatus.

### BACKGROUND

With the improvement of living standards, people are increasingly using various batteries (battery packs) in daily life. During the use of the batteries, charging is inevitably required. However, during the battery charging process, lithium plating may occur on a negative electrode, especially under low-temperature and fast-charging scenarios, which further increases the risk of lithium plating. Lithium plating on the negative electrode of the battery will degrade the battery performance, and dendritic lithium formed by plating may pierce a spacer in the battery, causing an internal short circuit and leading to safety incidents. Therefore, it is urgently needed to develop a method for can evaluating lithium plating inside the battery in real-time during charging.

### SUMMARY

The present application provides a lithium plating detection method for a battery based on a fiber-optic sensor, a battery, a battery system, and an electrical apparatus, and aims at solving the above problems.

The present application provides the lithium plating detection method for a battery based on the fiber-optic sensor, and the method includes: obtaining a first optical signal outputted by a fiber-optic sensor when a battery is being charged; obtaining a first spectral signal corresponding to the first optical signal, and obtaining a total envelope area of a cladding region of the first spectral signal when the battery is being charged based on the first spectral signal; obtaining a second spectral envelope area corresponding to an internal stress when the battery is being charged; calculating a difference between the total envelope area and the second spectral envelope area, so as to obtain a first spectral envelope area; and determining a lithium plating detection result for the battery based on the first spectral envelope area. By means of analysis of the spectral signals, the interference with lithium plating detection by the internal stress of the battery can be reduced, the first spectral envelope area corresponding to the lithium plating of the battery when the battery is being charged can be quickly obtained, and consequently the lithium plating circumstances inside the battery can be determined.

In some embodiments, the step of obtaining the second spectral envelope area corresponding to the internal stress when the battery is being charged includes: obtaining an actual internal stress when the battery is being charged; and obtaining the second spectral envelope area corresponding to the internal stress of the battery based on the actual internal stress and a mapping relationship, in which, the mapping relationship includes a corresponding relationship between the internal stress of the battery and the envelope area of the spectral signal under the internal stress. Therefore, by obtaining the mapping relationship between the internal stress and the envelope area when the battery is being charged, the second spectral envelope area corresponding to the internal stress when the battery is being charged can be quickly obtained, and thus the interference of the internal stress on the lithium plating detection result during the charging process can be reduced.

In some embodiments, before obtaining the actual internal stress when the battery is being charged, the lithium plating detection method for a battery also includes: charging the battery at a preset rate, and obtaining a second optical signal when the battery is being charged at the preset rate; obtaining the second spectral signal corresponding to the second optical signal, and recording the wavelength variation in the second spectral signal and the envelope area variation in the cladding region; obtaining stress data of the battery based on the wavelength variation in the second spectral signal and a stress analysis matrix of the battery; and fitting based on the stress data and the envelope area variation to obtain the mapping relationship. Therefore, before the battery is subjected to charging lithium plating detection, the battery can be charged at the preset rate to obtain the mapping relationship between the internal stress and the envelope area of different batteries, thereby improving the accuracy of the battery lithium plating detection result.

In some embodiments, the step of obtaining the actual internal stress when the battery is being charged includes: obtaining the wavelength variation of the first spectral signal; and obtaining the actual internal stress when the battery is being charged based on the wavelength variation in the first spectral signal and the stress analysis matrix of the battery. Therefore, the actual internal stress when the battery is being charged can be quickly obtained based on the wavelength variation of the first spectral signal and the stress analysis matrix corresponding to the battery, thereby improving the efficiency of detecting the lithium plating of the battery.

In some embodiments, the step of determining the lithium plating detection result of the battery based on the first spectral envelope area includes: in response to the first spectral envelope area being greater than or equal to a corresponding first preset envelope area threshold, determining that the battery is subjected to lithium plating; and in response to the first spectral envelope area being less than a corresponding first preset envelope area threshold and greater than or equal to a corresponding second preset envelope area threshold, determining that the battery has a lithium plating risk, in which, the second preset envelope area threshold is less than the first preset envelope area threshold. Therefore, the first spectral envelope area, the first preset envelope area threshold, and the second preset envelope area threshold corresponding to the lithium plating are compared, and whether the battery is subjected to lithium plating or has a lithium plating risk can be quickly determined, so that the lithium plating condition in the battery can be detected in real time, and the risk of safety problems caused by lithium plating in the battery is reduced.

In some embodiments, the step of determining the lithium plating detection result of the battery based on the first spectral envelope area includes: normalizing the first spectral envelope area; in response to the normalized first spectral envelope area being greater than or equal to the corresponding first preset percentage threshold, determining that the battery is subjected to lithium plating; and in response to the normalized first spectral envelope area being less than the corresponding first preset percentage threshold and greater than or equal to the corresponding second preset percentage threshold, determining that the battery has the lithium plating risk, in which, the second preset percentage threshold is less than the first preset percentage threshold. Therefore, by normalizing the first spectral envelope area, the problem that it is hard to give a unified lithium plating determination threshold due to the difference of different fiber-optic sensors can be solved.

In some embodiments, after the step of determining the lithium plating detection result of the battery based on the first spectral envelope area, the lithium plating detection method for a battery further includes: in response to the battery being subjected to lithium plating or having the lithium plating risk when being charged, adjusting a charging strategy for the battery. Therefore, if the battery is subjected to lithium plating or has the lithium plating risk when being charged, the charging strategy for the battery is adjusted to reduce the possibility of safety problems of the battery.

In some embodiments, the step of adjusting the charging strategy for the battery includes: in response to the lithium plating detection result showing the lithium plating risk, reducing a charging current of the battery to charge the battery until the lithium plating detection result of the battery shows no lithium plating risk; and in response to the lithium plating detection result showing the occurrence of lithium plating, stopping charging the battery and performing reverse discharging on the battery, and reducing the charging current of the battery when the battery is charged after reverse discharging. Therefore, when the battery is being charged, and the lithium plating detection result of the battery shows the lithium plating risk or the occurrence of lithium plating, the possibility of the safety problem of the battery in subsequent charging process can be reduced by reducing the charging current or stopping charging the battery and performing reverse charging, moreover, the charging speed can be increased to the maximum extent, thus avoiding lithium plating in the subsequent charging process, eliminating lithium partially plated from the battery, reducing the lithium plating harm.

The present application further provides a battery. The battery includes a battery body, at least one fiber-optic sensor, and a control module; a detection part of the fiber-optic sensor is arranged inside the battery body, the fiber-optic sensor is configured to output an optical signal when the battery is being charged, and the control module is connected to the fiber-optic sensor; the control module is configured to obtain the first spectral signal corresponding to the optical signal, and obtain the total envelope area of the cladding region of the first spectral signal when the battery is being charged based on the first spectral signal, obtain the second spectral envelope area corresponding to the internal stress when the battery is being charged, calculate the difference value between the total envelope area and the second spectral envelope area so as to obtain the first spectral envelope area, and determine the lithium plating detection result of the battery based on the first spectral envelope area. Therefore, according to the battery in the present application, the optical signal when the battery is being charged can be obtained by the detection part of the fiber-optic sensor inside the battery body, and the control module can analyze the spectral signal corresponding to the optical signal, thereby reducing the interference of the internal stress of the battery on the lithium plating detection, quickly obtaining the first spectral envelope area corresponding to the lithium plating when the battery is being charged, thereby confirming the lithium plating situation inside the battery and reducing the risk of safety problems of the battery.

In some embodiments, the fiber-optic sensor includes at least one grating part and a transmission optical fiber connected to the grating part, and the grating part is arranged inside the battery body. Therefore, the fiber-optic sensor can obtain the optical signal when the battery is being charged through the grating part arranged inside the battery.

In some embodiments, an input end and an output end of the transmission optical fiber are both arranged outside the battery body, and a middle connecting part of the input end and the output end of the transmission optical fiber is arranged inside the battery body. Therefore, by inputting an initial optical signal at the input end and analyzing the optical signal outputted by the output end of the transmission optical fiber, the lithium plating detection result inside the battery during the charging process can be obtained.

In some embodiments, a reflecting layer is arranged inside the battery body, the input end of the transmission optical fiber is arranged outside the battery body, and the output end of the transmission optical fiber is arranged inside the battery body and abuts against the reflecting layer, in which, the reflecting layer is configured to reflect the initial optical signal incident from the input end so as to transmit the output optical signal from the input end to the outside. Therefore, the reflecting layer is arranged inside the battery, so it is not needed to lead the output end of the transmission optical fiber out of the battery, the battery structure is simplified, and the convenience of battery manufacturing is improved.

In some embodiments, the transmission optical fiber includes a fiber core and a cladding layer, and the diameter of the cladding layer is set to be 25-125 µm. Therefore, the possible negative influence caused by the transmission optical fiber on the battery can be reduced by setting the diameter of the cladding to be 25-125 µm, and the transmission optical fiber can also have good mechanical property.

In some embodiments, the transmission optical fiber includes the fiber core and the cladding layer, and the diameter of the cladding is set to be 50-100 µm. Therefore, the negative influence possibly caused by the transmission optical fiber on the battery can be further reduced, and the mechanical property of the transmission optical fiber is further improved.

In some embodiments, the length of the grating part is set to be 0.3-1.2 cm. Therefore, the efficiency and the precision of obtaining the optical signal can be improved by setting the length of the grating part to be 0.3-1.2 cm, and the possible negative influence caused by the transmission optical fiber on the battery is reduced.

In some embodiments, the length of the grating part is set to be 0.5-1 cm. Therefore, the efficiency and precision of obtaining the optical signal can be further improved, and the possible negative influence caused by the transmission optical fiber on the battery is further reduced.

In some embodiments, the control module includes an optical demodulation module and a battery management module; the optical demodulation module is connected to the fiber-optic sensor and is configured to modulate the optical signal outputted by the fiber-optic sensor when the battery is being charged so as to obtain the first spectral signal; the battery management module is connected to the optical demodulation module and is configured to obtain the total envelope area of the cladding region of the first spectral signal when the battery is being charged based on the first spectral signal, obtain the second spectral envelope area corresponding to internal stress when the battery is being charged, calculate the difference value between the total envelope area and the second spectral envelope area so as to obtain the first spectral envelope area, and determine the lithium plating detection result of the battery based on the first spectral envelope area. Therefore, the optical demodulation module can demodulate the optical signal of the fiber-optic sensor to obtain the first spectral signal, and the battery management module can analyze the lithium plating condition in the battery based on the first spectral signal, so that the interference of the internal stress of the battery on lithium plating detection can be reduced to obtain the lithium plating detection result of the battery, the harm of lithium plating in the battery can be effectively reduced, and safety accidents caused by lithium plating of the battery are reduced.

The present application further provides a battery system, which includes the abovementioned battery and a charge-discharge control module; the charge-discharge control module is connected to the control module and the battery and is configured to, in response to the occurrence of lithium plating or the lithium plating risk when the battery is being charged, adjust the charging strategy for the battery. Therefore, if the battery is subjected to lithium plating or has the lithium plating risk when being charged, the charge-discharge control module can adjust the charging strategy for the battery, so that the possibility that the battery has a safety problem can be reduced.

The present application further provides an electrical apparatus, which includes any battery system as described above.

Different from the existing technology, the lithium plating detection method for a battery provided by the present application has the advantages that by means of analyzing the spectral signal, the interference of the internal stress of the battery on lithium plating detection can be reduced, the first spectral envelope area corresponding to lithium plating when the battery is being charged can be quickly obtained, and the lithium plating condition in the battery can be confirmed, thus the harm of lithium plating in the battery can be effectively reduced, and the safety accidents caused by battery lithium plating can be reduced. It is to be understood that both the foregoing general description and the following detailed description are exemplary and explanatory only and are not restrictive of the present application.

### BRIEF DESCRIPTION OF THE DRAWINGS

The accompanying drawings here are incorporated into the specification and constitute a part of this specification. These accompanying drawings illustrate embodiments in accordance with the present application and are used together with the specification to describe the technical solutions of the present application.
FIG. 1 is a schematic structural diagram of a vehicle according to an embodiment of the present application;
FIG. 2 is a schematic structural diagram of a battery system according to an Embodiment 1 of the present application;
FIG. 3 is a schematic structural diagram of a battery system according to an Embodiment 2 of the present application;
FIG. 4 is an exploded schematic structural diagram of a battery according to an embodiment of the present application;
FIG. 5 is an exploded schematic diagram of a battery cell according to an embodiment of the present application;
FIG. 6 is a schematic structural diagram of a battery according to an Embodiment 2 of the present application;
FIG. 7 is a spectral schematic diagram of a tilted fiber bragg grating fiber-optic sensor according to an embodiment of the present application;
FIG. 8 is a schematic structural diagram of a battery according to an Embodiment 3 of the present application;
FIG. 9 is a schematic structural diagram of a battery according to an Embodiment 4 of the present application;
FIG. 10 is a flow schematic diagram of a lithium plating detection method for a battery based on a fiber-optic sensor according to an Embodiment 1 of the present application;
FIG. 11 is a curve diagram of a lithium plating determination solution according to an Embodiment 1 of the present application;
FIG. 12 is a curve diagram of a lithium plating determination solution according to an Embodiment 2 of the present application;
FIG. 13 is a flow schematic diagram of step S103 according to an Embodiment 1 in FIG. 10;
FIG. 14 is a flow schematic diagram of step S201 according to an Embodiment 1 in FIG. 13;
FIG. 15 is a flow schematic diagram of step S103 according to an Embodiment 2 in FIG. 10;
FIG. 16 is a flow schematic diagram of step S105 according to an Embodiment 1 in FIG. 10;
FIG. 17 is a flow schematic diagram of step S105 according to an Embodiment 2 in FIG. 10;
FIG. 18 is a flow schematic diagram of charging strategy adjustment according to an embodiment of the present application.

### DETAILED DESCRIPTION

Embodiments of the technical solutions of the present application will be described in detail below with reference to the drawings. The following embodiments are only used to illustrate the technical solutions of the present application more clearly, and thus are only interpreted as examples, rather than used to limit the scope of protection of the present application.

Unless otherwise defined, all technical and scientific terms used herein have the same meanings as those commonly understood by those skilled in the art of the present application. The terms used herein are intended only for the purpose of describing specific embodiments and are not intended to limit the present application. The terms "including" and "having" and any variations thereof in the specification and claims of the present application and in the description of the above accompanying drawings are intended to cover non-exclusive inclusion.

In the description of the embodiments of the present application, the technical terms "first", "second", etc., are only used for distinguishing different objects, and cannot be understood as indicating or implying relative importance or implying the number, specific order or primary and secondary relationship of the technical features indicated. In the description of the embodiments of the present application, the meaning of "a plurality of" is two or more, unless otherwise explicitly and specifically defined.

The "embodiment" mentioned herein means that specific features, structures, or characteristics described with reference to the embodiment may be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiment of the present application, the term "a plurality of" refers to more than two (including two), similarly, "a plurality of groups" refers to two or more groups (including two groups), and "a plurality of members" refers to more than two members (including two members).

In the description of the embodiments of the present application, unless otherwise expressly specified and limited, the technical terms "mount," "connect," "connection," "fix", etc. should be understood in a broad sense, such as, a fixed connection, a detachable connection, or an integral connection; a mechanical connection, or an electrical connection; directly connect, indirectly connect through an intermediate medium, an internal communication of two elements, or interaction between two elements. For those of ordinary skill in the art, the specific meaning of the above terms in the present application may be understood on a case-by-case basis.

A lithium plating detection method for a battery based on a fiber-optic sensor disclosed by the embodiment of the present application can be applied to an electrical apparatus using a battery as a power supply or various energy storage systems using the battery as an energy storage element, or can also be applied to other computer devices establishing communication connection with the electrical apparatus. The electrical apparatus can be but not limited to mobile phones, tablet computers, notebook computers, electric toys, electric tools, electric vehicles, electric automobiles, ships, spacecraft and the like. The electric toys can include a fixed or mobile electric toy, such as a game machine, an electric automobile toy, an electric ship toy and an electric aircraft toy, and the spacecraft can include an aircraft, a rocket, a space shuttle, a spacecraft and the like.

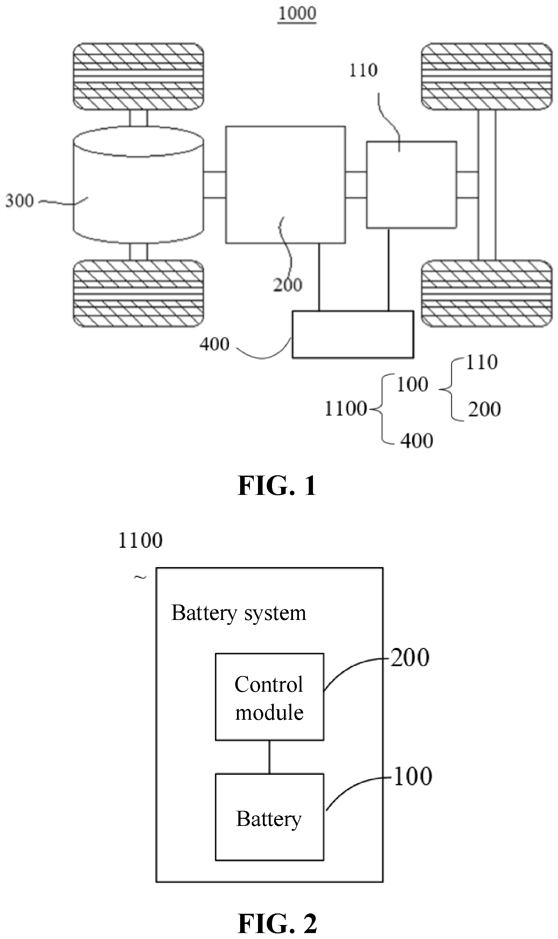

As shown in to FIG. 1, the present application provides an electrical apparatus. The electrical apparatus includes a battery system, which includes a battery and a charge-discharge control module; the battery includes a control module, a battery body, and at least one fiber-optic sensor; and the control module is configured to execute any one lithium plating detection method for a battery based on the fiber-optic sensor provided by the present application.

The following embodiments, for the convenience of illustration, take a vehicle being an electrical apparatus in one embodiment of the present application as an example to illustrate.

With reference to FIG. 1, FIG. 1 is a schematic structural diagram of a vehicle according to one embodiment of the present application. The vehicle 1000 may be a fuel vehicle, a gas vehicle or a new energy vehicle, and the new energy vehicle may be a pure electric vehicle, a hybrid electric vehicle or an extended-range vehicle and the like. A vehicle 1000 includes a battery system 1100, and the battery system 1100 includes a battery 100 and a charge-discharge control module 400; the charge-discharge control module 400 is configured to perform charge-discharge control on the battery 100; the battery 100 includes a battery body 110 and a control module 200; and the battery 100 can be arranged at the bottom or the head or the tail of the vehicle 1000. The battery 100 can be configured to supply power to the vehicle 1000, for example, the battery 100 can be used as an operation power supply of the vehicle 1000. The vehicle 1000 can also include a motor 300; the control module 200 can execute any one lithium plating detection method for a battery provided by the present application when the battery 100 is being charged, and can also be configured to control the battery 100 to supply power to the motor 300, for example, the control module 200 is configured to meet the working power consumption requirements during starting, navigation and running of the vehicle 1000.

In some embodiments of the present application, the battery 100 can serve as the operation power source of the vehicle 1000 and can also serve as a driving power source of the vehicle 1000, and replaces or partially replace fuel oil or natural gas to provide driving power for the vehicle 1000.

The battery 100 in the embodiment can be a pack containing the control module, and can also be a battery cell, a battery module or a battery pack module not containing the control module. The battery cell may be the minimum unit which forms the battery. Each battery cell can be a secondary battery or a primary battery, and can also be a lithium-sulfur battery, a sodium-ion battery or a magnesium-ion battery, but not limited thereto. The battery cell can be in a cylinder shape, a flat body shape, a cuboid shape or other shapes. The battery module can be regarded as a whole body obtained by connecting a plurality of battery cells in series or in parallel or in a series-parallel combination and is accommodated in a box. Series-parallel connection refers to that the plurality of battery cells are connected in series and in parallel. For example, the plurality of battery cells can be directly connected in series or in parallel or in series-parallel connection, and then, a whole body formed by the plurality of battery cells is accommodated in the box. The battery module can also be in a battery module form formed by connecting a plurality of battery cells in series or in parallel or in a series-parallel combination; and the plurality of battery modules are connected in series or in parallel or in a series-parallel combination to form a whole body and are accommodated in the box.

With reference to FIG. 2, FIG. 2 is a structural schematic diagram of a battery system according to an Embodiment 1 of the present application. As shown in FIG. 2, the battery system 1100 in the embodiment includes the battery 100 and the control module 200.

In the embodiment, the battery 100 can include at least one battery pack module which can provide energy and power for the electric vehicle. In terms of category, the battery 100 may be a lithium-ion battery, a lithium metal battery, a lead-acid battery, a nickel-cadmium battery, a nickelmetal hydride battery, a lithium-sulfur battery, a lithium-air battery, or a sodium-ion battery, which is not specifically limited in the present application. In the embodiment of the present application, in terms of battery scale, the battery pack module in the battery 100 can be the battery cell, or the battery pack, which is not specifically limited in the embodiment of the present application.

In addition, in order to intelligently manage and maintain the battery 100, prevent the battery 100 from breaking down and prolong the service life of the battery 100, the control module 200 is also arranged in the battery system 1100 generally, is connected to the power battery 100, is configured to monitor and acquire parameters of the battery 100, and can also realize control management on the battery 100 according to the parameters.

As an example, the control module 200 can be configured to monitor the parameters such as voltage, current and temperature of the battery 100. The control module 200 can acquire the total voltage and total current of the battery 100, the voltage and current of a single battery cell in the battery 100, the temperature of at least one temperature measuring point in the battery 100 and the like in real time. Real-time, rapid and accurate measurement of the parameters is the basis of normal operation of the control module 200.

Optionally, the control module 200 can further estimate various parameters such as state of charge (SOC), state of health (SOH), and state of power (SOP) of the battery 100 according to the acquired parameters of the battery 100. Further, after obtaining the various parameters of the battery 100, the control module 200 can perform various control and management on the battery 100 according to the various parameters.

For example, the control module 200 can perform charge-discharge control on the battery 100 according to parameters such as SOC, voltage, current, and optical signals, thus ensuring normal energy supply and release of the battery 100. For another example, the control module 200 can also control assemblies such as a cooling fan or a heating module according to parameters like temperature, thus realizing thermal management on the battery 100 is realized. For yet another example, the control module 200 can also determine whether the battery 100 is in a normal operation state according to parameters such as voltage and SOH, so as to realize fault diagnosis and early warning of the battery 100.

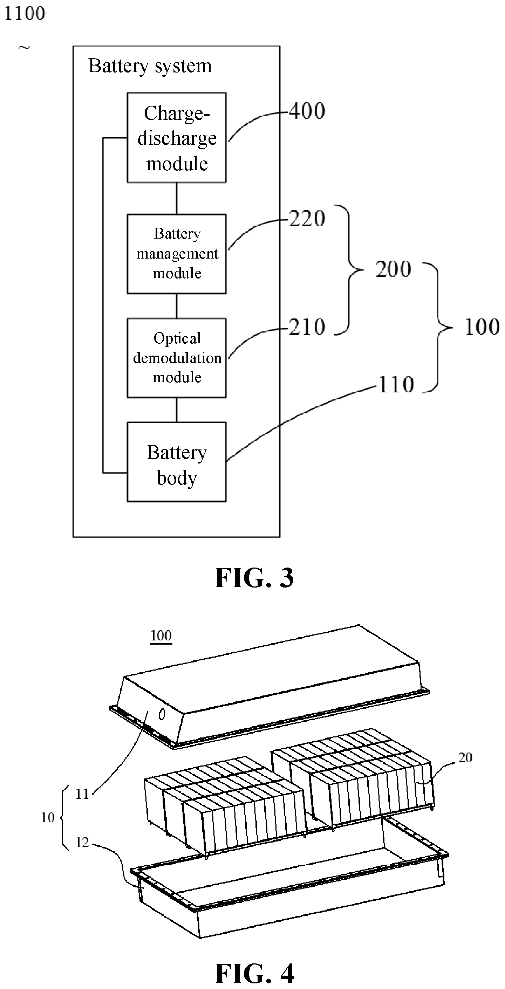

In some embodiments of the present application, with reference to FIG. 3, FIG. 3 is a schematic structural diagram of a battery system according to an Embodiment 2 of the present application. As shown in FIG. 3, the battery system 1100 includes the battery 100 and the charge-discharge control module 400; the battery 100 in the embodiment includes the control module 200 and a battery body 110, in which, the charge-discharge control module 400 is connected to the control module 200 and the battery body 110; and when the battery is being charged, the control module 200 is connected to the fiber-optic sensor on the battery body 110 and is configured to obtain a first spectral envelope area corresponding to battery lithium plating based on an optical signal outputted by the fiber-optic sensor, obtain a total envelope area of a cladding region of a first spectral signal when the battery is being charged based on the first spectral signal, obtain a second spectral envelope area corresponding to an internal stress when the battery is being charged, calculate a difference value between the total envelope area and the second spectral envelope area so as to obtain the first spectral envelope area, and determine a lithium plating detection result of the battery based on the first spectral envelope area; and the charge-discharge control module 400 is connected to the control module 200 and the battery body 110 and is configured to, in response to the occurrence of lithium plating or the lithium plating risk when the battery is being charged, adjust the charging strategy for the battery 100.

In some embodiments, as shown in FIG. 3, the control module 200 includes an optical demodulation module 210 and a battery management module 220.

The optical demodulation module 210 is connected to the fiber-optic sensor and is configured to modulate the optical signal outputted by the fiber-optic sensor when the battery 100 is being charged so as to obtain the first spectral signal; and the battery management module 220 is connected to the optical demodulation module 210 and is configured to obtain the total envelope area of the cladding region of the first spectral signal when the battery is being charged based on the first spectral signal, obtain the second spectral envelope area corresponding to the internal stress when the battery is being charged, calculate the difference value between the total envelope area and the second spectral envelope area so as to obtain the first spectral envelope area, and determine the lithium plating detection result of the battery based on the first spectral envelope area.

Therefore, if the battery 100 is subjected to lithium plating or has a lithium plating risk during the charging process, the charging strategy for the battery 100 can be adjusted by the charge-discharge control module 400, so that the possibility of safety problems of the battery can be reduced.

With reference to FIG. 4, FIG. 4 is an exploded schematic structural diagram of a battery according to an embodiment of the present application. As described above, the battery 100 in the embodiment can be the pack containing the control module, and can also be the battery cell, the battery module or the battery pack module without the control module. As shown in FIG. 3, in the embodiment, the battery 100 includes a battery box 10 and the battery cell 20, and the battery cell 20 is accommodated in the battery box 10. The battery box 10 is configured to provide an accommodating space for the battery cell 20, and the battery box 10 can be of various structures. In some embodiments, the battery box 10 may include a first part 11 and a second part 12, the first part 11 and the second part 12 covering each other, and the first part 11 and the second part 12 together defining the accommodating space for accommodating the battery cell 20. The second part 12 may be of a hollow structure with an opening at one end, and the first part 11 may be of a plate-like structure, where the first part 11 covers the opening side of the second part 12 so that the first part 11 and the second part 12 together define the accommodating space. The first part 11 and the second part 12 may each be of a hollow structure with an opening at one end, where the opening side of the first part 11 covers the opening side of the second part 12. Definitely, the battery box 10 formed by the first part 11 and the second part 12 can be in various shapes, such as a cylinder and a cuboid.

In the battery 100, there may be a plurality of battery cells 20 which can be connected in series or in parallel or in series-parallel, and the series-parallel connection refers to that the plurality of battery cells 20 are connected in series and in parallel. The plurality of battery cells 20 can be directly connected together in series or in parallel or in mixed connection, and then the whole composed of the plurality of battery cells 20 can be accommodated in the battery box 10; and of course, the battery 100 may also be in the form of a battery module first formed by the plurality of battery cells 20 being connected in series or in parallel or in mixed connection, then multiple battery modules can be connected in series or in parallel or in mixed connection to form a whole, and accommodated in the battery box 10. The battery 100 may further comprise other structures, for example, the battery 100 may further include a bus component for realizing electrical connections between the plurality of battery cells 20.

Each battery cell 20 may be a secondary battery or a primary battery; or it may be a lithium-sulfur battery, a sodium-ion battery or a magnesium-ion battery, but is not limited thereto. The battery cell 20 can be in a cylinder shape, a flat body shape, a cuboid shape or other shapes.

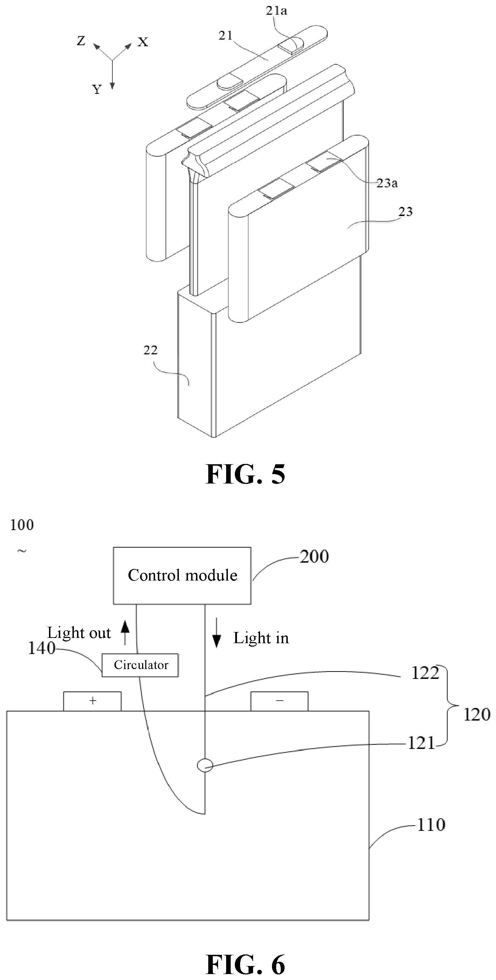

With reference to FIG. 5, FIG. 5 is a schematic exploded view of a battery cell provided by an Embodiment 1 of the present application. The battery cell 20 refers to a minimum unit forming the battery. As shown in FIG. 3, the battery cell 20 includes an end cover 21, a case 22, an electrode assembly 23, and other functional components.

The end cover 21 refers to a component that covers an opening of the case 22 to isolate an internal environment of the battery cell 20 from an external environment. Without limitation, the shape of the end cover 21 may match the shape of the case 22 so as to fit the case 22. Optionally, the end cover 21 may be made of a material (such as an aluminum alloy) with a certain hardness and strength, so that the end cover 21 is not easy to be deformed when being pressed and collided, the battery cell 20 can have a higher structural strength, and the safety performance can also be improved. Functional components such as electrode terminals 21a may be arranged on the end cover 21. The electrode terminals 21a can be configured to electrically connect to the electrode assembly 23 for use in outputting or inputting electrical energy from or to the battery cell 20. In some embodiments, the end cover 21 may be further provided with a pressure relief mechanism configured to relieve internal pressure when the internal pressure or temperature of the battery cell 20 reaches a threshold. The end cover 21 may be made of various materials, such as copper, iron, aluminum, stainless steel, an aluminum alloy, and plastic, which is not particularly limited in this embodiment of the present application. In some embodiments, an insulating member may be further provided on an inner side of the end cover 21 and may be used for isolating an electrical connection component in the case 22 from the end cover 21, thereby reducing the risk of short circuit. For example, the insulating member may be made of plastic, rubber, and the like.

The case 22 is an assembly matched with the end cover 21 to form the internal environment of the battery cell 20, in which, the formed internal environment can be used for accommodating the electrode assembly 23, the electrolyte and other components. The sensor can be arranged at the inner bottom of the case 22, for example, a corner of the case 22. The case 22 and the end cover 21 can be independent components; an opening can be formed in the case 22; and the end cover 21 covers the opening at the opening position to form the internal environment of the battery cell 20. Without limitation, the end cover 21 and the case 22 may also be integrated. Specifically, the end cover 21 and the case 22 may form a common connection surface before other components enter the case. When an interior of the case 22 is required to be encapsulated, the end cover 21 is enabled to cover the case 22. The case 22 may be in various shapes and sizes, such as a cuboid, a cylinder, or a hexagonal prism. Specifically, the shape of the case 22 may be determined according to the specific shape and size of the electrode assembly 23. The shell 22 may be made of various materials, such as copper, iron, aluminum, stainless steel, aluminum alloy, and plastic. This is not specially limited in the embodiments of the present application.

The electrode assembly 23 is a component of a battery cell 100 where an electrochemical reaction occurs. One or more electrode assemblies 23 may be included within the shell 22. The electrode assembly 23 is mainly formed by winding or laminating a positive electrode plate and a negative electrode plate, and a diaphragm is usually arranged between the positive electrode plate and the negative electrode plate. The portions, with active materials, of the positive electrode plate and the negative electrode plate constitute a main body part of the electrode assembly, and the portions, without the active materials, of the positive electrode plate and the negative electrode plate respectively constitute tabs 23a. The positive tab and the negative tab may be located at one end of the main body part together or located at two ends of the main body part respectively. In the charging and discharging process of the battery, a positive electrode active substance and a negative electrode active substance react with the electrolyte, and the tabs 23a are connected to the electrode terminal to form a current loop.

With reference to FIG. 6, FIG. 6 is a schematic structural diagram of a battery provided by an Embodiment 2 of the present application. As shown in FIG. 6, the battery 100 includes the battery body 110, at least one fiber-optic sensor 120, and the control module 200; a detection part of the fiber-optic sensor 120 is arranged inside the battery body 110; the fiber-optic sensor 120 is configured to output the optical signal when the battery 100 is being charged; the control module 200 is connected to the fiber-optic sensor 120; the control module 200 is configured to obtain the first spectral signal corresponding to the optical signal, and obtain the total envelope area of the cladding region of the first spectral signal when the battery is being charged based on the first spectral signal, obtain the second spectral envelope area corresponding to the internal stress when the battery is being charged, calculate the difference value between the total envelope area and the second spectral envelope area so as to obtain the first spectral envelope area, and determine the lithium plating detection result of the battery based on the first spectral envelope area.

In the embodiment, the fiber-optic sensor 120 can be set as a tilted bragg fiber grating (TFBG) fiber-optic sensor. The TFBG fiber-optic sensor is a special fiber grating. It is different from a general TFBG fiber-optic sensor in that a certain intersection angle is formed between a grating wave vector direction and an optical fiber axis direction.

According to the present application, the detection part of the fiber-optic sensor 120 is arranged inside the battery body 110, and if the fiber-optic sensor 120 is the TFBG fiber-optic sensor, the grating part 121 of the TFBG fiber-optic sensor is arranged inside the battery body 110.

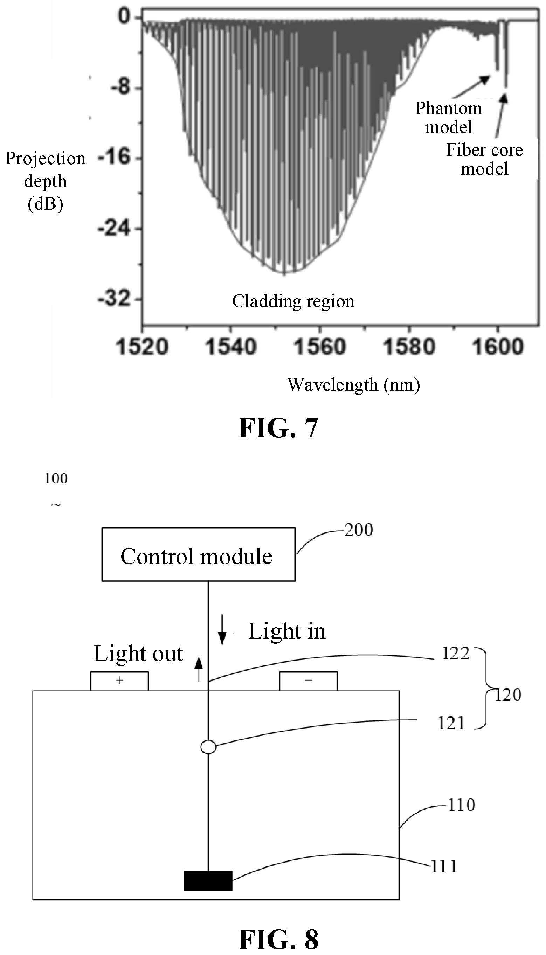

The principle of lithium plating detection using the TFBG fiber-optic sensor is as follows: the optical signal outputted by the TFBG fiber-optic sensor is demodulated to obtain a spectrum diagram as shown in FIG. 7. As shown in FIG. 7, FIG. 7 is a spectral schematic diagram of a tilted fiber bragg grating fiber-optic sensor according to an embodiment of the present application. In FIG. 7, a region like a "comb" is its cladding region. The cladding region is quite sensitive to changes in the ion concentration in an electrolyte solution inside the battery 100. If a negative electrode of the battery 100 is charged to a certain state of charge, the ion concentration on its surface is closely related to lithium plating; if the ion concentration exceeds a certain value, lithium plating begins on the surface of the negative electrode; therefore, the spectral signal of the battery can be obtained by demodulating the optical signal of the fiber-optic sensor 120, and the changes in the cladding region area of the spectral signal can be monitored to realize real-time lithium plating detection; and specifically, it is possible to determine whether the battery 100 is subjected to lithium plating by calculating the envelope area enclosed by upper and lower envelope lines of the cladding region and comparing it with the threshold.

According to the battery 100 in the present application, the optical signal when the battery 100 is being charged can be obtained by the detection part of the fiber-optic sensor 120 inside the battery body 110, and the control module 200 can analyze the spectral signal corresponding to the optical signal, thereby reducing the interference of the internal stress of the battery on the lithium plating detection, quickly obtaining the first spectral envelope area corresponding to the lithium plating when the battery is being charged, thereby confirming the lithium plating situation inside the battery 100 and reducing the risk of safety problems of the battery 100.

In some embodiments, as shown in FIG. 6, the fiber-optic sensor 120 includes at least one grating part 121 and a transmission optical fiber 122 connected to the grating part, and the grating part 121 is arranged in the battery body 110. Therefore, the fiber-optic sensor 120 can obtain the optical signal when 100 the battery is being charged through the grating part 121 arranged in the battery 100.

In some embodiments, as shown in FIG. 6, the input end of the transmission optical fiber 122 is configured to transmit an initial optical signal while the output end thereof is configured to output the optical signal during the charging process; the input end and the output end of the transmission optical fiber 122 are both arranged outside the battery body 110, and a middle connecting part of the input end and the output end of the transmission optical fiber 122 is arranged in the battery body 110.

In the embodiments, the transmission optical fiber 122 is arranged to be connected to an optical demodulation module (not shown in figure), the optical demodulation module inputs the initial optical signal from the input end and receives the optical signal outputted by the output end of the transmission optical fiber 122, and at the moment, if the optical demodulation module needs to receive the optical signal outputted by the output end, a circulator 140 is needed.

Therefore, by means of inputting the initial optical signal at the input end and analyzing the optical signal outputted by the output end of the transmission optical fiber, the lithium plating detection result in the battery during the charging process can be quickly obtained, thus effectively reducing the harm of lithium plating in the battery 100, and reducing safety accidents caused by lithium plating of the battery 100.

In some embodiments, with reference to FIG. 8, FIG. 8 is a schematic structural diagram of a battery according to an Embodiment 3 of the present application. As shown in FIG. 8, the control module 200 is connected to the fiber-optic sensor 120, the battery body 110 is internally provided with a reflecting layer 111, the input end of the transmission optical fiber 122 is arranged outside the battery body 110, the output end of the transmission optical fiber 122 is arranged inside the battery body 110 and abuts against the reflecting layer 111, and the reflecting layer 111 is configured to reflect the initial optical signal incident from the input end so as to transmit the outputted optical signal from the input end to the outside.

The material of the reflecting layer 111 includes, but is not limited to, gold or monocrystalline silicon and other materials. In the embodiments, due to the arrangement of the reflecting layer 111, the optical signal which originally needs to be outputted from the output end is directly transmitted out from the incident end, and such design does not need to lead the output end of the transmission optical fiber 122 out of the battery 100 again, and does not need the circulator 140.

Therefore, the battery 100 is internally provided with the reflecting layer 111, and it is not needed to lead the output end of the transmission optical fiber 122 out of the battery, thereby simplifying the structure of the battery 100, and improving the convenience of manufacturing the battery 100.

In some embodiments, based on the above embodiments, the transmission optical fiber 122 includes a fiber core and a cladding layer, and the diameter of the cladding is set to be 25-125 µm. Therefore, the possible negative influence caused by the transmission optical fiber 122 on the battery 100 can be reduced by setting the diameter of the cladding to be 25-125 µm, and the transmission optical fiber 122 can also have good mechanical property.

In some embodiments, the transmission optical fiber 122 includes the fiber core and the cladding layer, and the diameter of the cladding is set to be 50-100 µm.

Preferably, the diameter of the cladding layer is 50 µm.

Therefore, the negative influence possibly caused by the transmission optical fiber 122 on the battery 100 can be further reduced, and the mechanical property of the transmission optical fiber 122 is further improved.

In some embodiments, the length of the grating part 121 is set to be 0.3-1.2 cm. Therefore, the efficiency and the precision of obtaining the optical signal can be improved by setting the length of the grating part 121 to be 0.3-1.2 cm, and the possible negative influence caused by the transmission optical fiber 122 on the battery 100 is reduced.

In some embodiments, the length of the grating part 121 is set to be 0.5-1 cm. Therefore, the efficiency and precision of obtaining the optical signal can be further improved, and the possible negative influence caused by the transmission optical fiber 122 on the battery 100 is further reduced.

In addition, in the embodiments, the grating period and the central wavelength of the fiber-optic sensor 120 can be not limited, and the inclination angle of the grating part 121 can be set to be 1-45°.

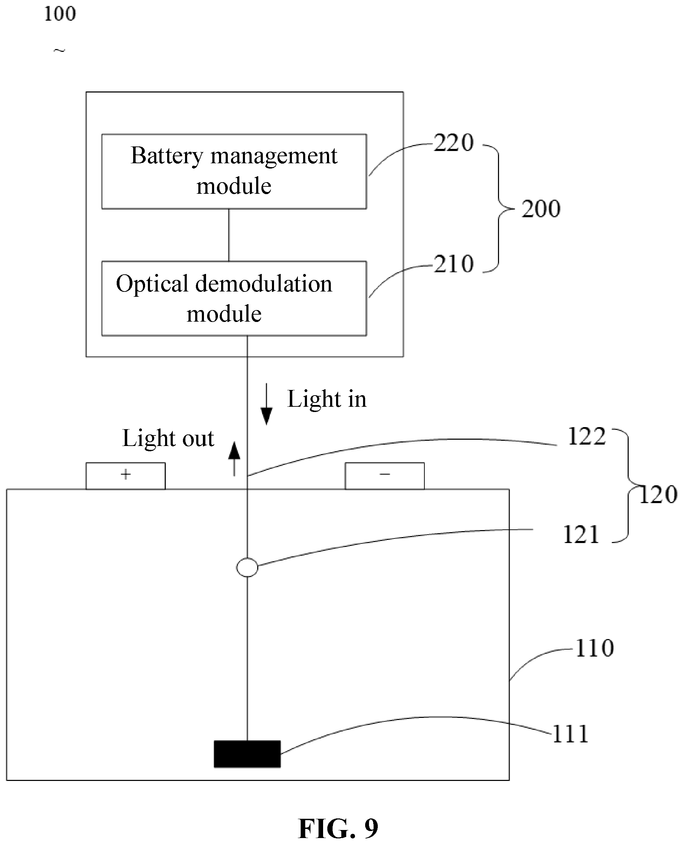

In some embodiments, with reference to FIG. 9, FIG. 9 is a schematic structural diagram of a battery according to an Embodiment 4 of the present application.

In some embodiments, as shown in FIG. 9, the control module 200 includes the optical demodulation module 210 and the battery management module 220; the optical demodulation module 210 is connected to the fiber-optic sensor 120 and is configured to modulate the optical signal outputted by the fiber-optic sensor 120 when the battery is being charged so as to acquire the first spectral signal; and the battery management module 220 is connected to the optical demodulation module 210 and is configured to obtain the total envelope area of the cladding region of the first spectral signal when the battery is being charged based on the first spectral signal, obtain the second spectral envelope area corresponding to internal stress when the battery is being charged, calculate the difference value between the total envelope area and the second spectral envelope area so as to obtain the first spectral envelope area, and determine the lithium plating detection result of the battery based on the first spectral envelope area.

The battery management module 220 includes one of a BMS system and a VCU.

The BMS system (Battery Management System) is commonly known as a battery nanny or battery steward, and it is mainly configured to intelligently manage and maintain each battery cell, such as preventing overcharging and over-discharging, prolonging battery life, and monitoring the battery status. The VCU can be regarded as a vehicle control unit. The vehicle control unit is a key device in the electronic control system of pure electric vehicles. Similar to the function of an engine management system (EMS) in traditional internal combustion engine vehicles, the vehicle control unit of a pure electric vehicle can allocate energy reasonably and maximize the efficiency of onboard battery energy utilization. The electronic control unit (VCU) of the vehicle control unit is the core of the vehicle control unit system. Today, electronic devices on the electric vehicles are increasingly numerous, the control systems are getting more complex, and an advanced vehicle control structure is important for ensuring safe and reliable vehicle operation as well as improving data transmission efficiency between various control systems. The vehicle control system of the electric vehicle is a control system capable of realizing motor drive control, temperature control, energy management control, and other functions, mainly composed of subsystems such as sensor input and switching systems, system drive output, and control unit output systems.

Therefore, the optical demodulation module 210 can demodulate the optical signal of the fiber-optic sensor to obtain the first spectral signal, and the battery management module 220 can analyze the lithium plating condition in a battery based on the first spectral signal to obtain the lithium plating detection result of the battery, so that the harm of lithium plating in the battery can be effectively reduced, and safety accidents caused by lithium plating of the battery can be reduced.

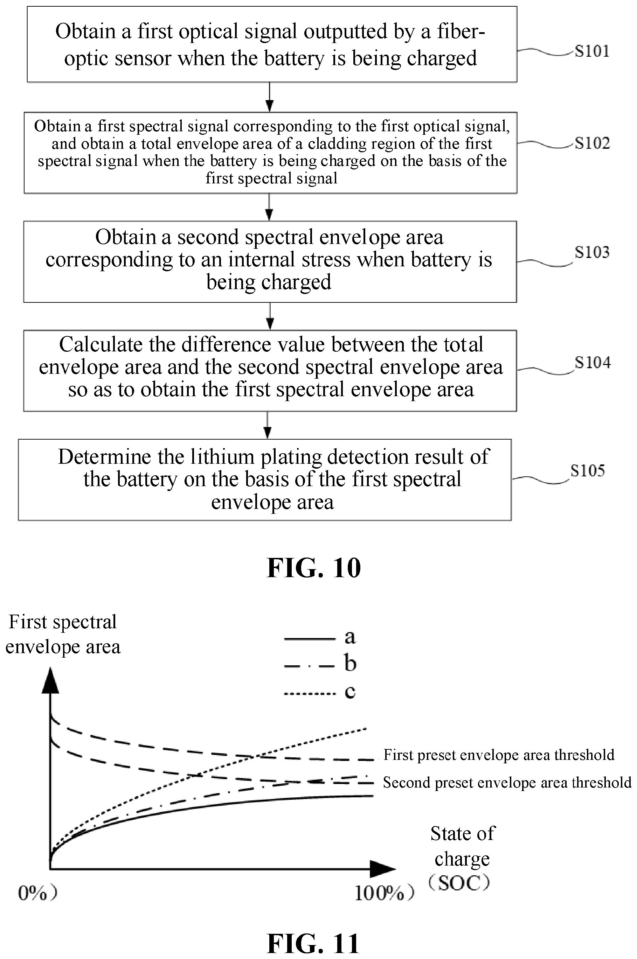

Optionally, with reference to FIG. 10, FIG. 10 is a flow schematic diagram of a lithium plating detection method for a battery based on a fiber-optic sensor according to an Embodiment 1 of the present application. As shown in FIG. 10, the lithium plating detection method for a battery specifically includes steps S101 to S105: step S101: obtain the first optical signal outputted by the fiber-optic sensor when the battery is being charged. Step S102: Obtain the first spectral signal corresponding to the first optical signal, and obtain the total envelope area of the cladding region of the first spectral signal when the battery is being charged based on the first spectral signal. Step S103: obtain the second spectral envelope area corresponding to the internal stress when the battery is being charged. Step S104: calculate the difference value between the total envelope area and the second spectral envelope area so as to obtain the first spectral envelope area. Step S105: determine the lithium plating detection result of the battery based on the first spectral envelope area.

The lithium plating detection method for a battery based on the fiber-optic sensor can be applied to the electrical apparatus provided by the electrical apparatus embodiment and can also be applied to the battery 100 provided by the battery embodiment. The battery can be any one of the above, such as the pack containing the controller, the battery cell, the battery module or the battery pack module.

As described above, the cladding region is quite sensitive to changes in the ion concentration in the electrolyte solution inside the battery. If the negative electrode of the battery is charged to a certain state of charge, the ion concentration on its surface is closely related to lithium plating; if the ion concentration exceeds a certain value, lithium plating begins on the surface of the negative electrode; therefore, the spectral signal of the battery can be obtained by demodulating the optical signal of the fiber-optic sensor, and the changes in the cladding region area of the spectral signal can be monitored to realize real-time lithium plating detection; and specifically, it is possible to determine whether the battery is subjected to lithium plating by calculating the envelope area enclosed by upper and lower envelope lines of the cladding region and comparing it with the threshold.

However, besides being influenced by the ion concentration, the cladding region is also interfered by the internal stress of the battery, so that after obtaining the total envelope area enclosed by the upper and lower envelope lines of the cladding region of the spectral signal, it is needed to calculate the second spectral envelope area corresponding to the internal stress when the battery is being charged; and the first spectral envelope area corresponding to the lithium plating of the battery can be obtained by subtracting the second spectral envelope area from the total envelope area.

In the above solution, the lithium plating detection method for a battery can reduce the interference of the internal stress of the battery on the lithium plating detection by analyzing the spectral signal, and quickly obtain the first spectral envelope area corresponding to the lithium plating when the battery is being charged, thereby confirming the lithium plating condition in the battery.

In some embodiments, the step of obtaining the second spectral envelope area corresponding to the internal stress when the battery is being charged includes: obtaining an actual internal stress when the battery is being charged; and obtaining the second spectral envelope area corresponding to the internal stress of the battery based on the actual internal stress and a mapping relationship, in which, the mapping relationship includes a corresponding relationship between the internal stress of the battery and the envelope area of the spectral signal under the internal stress.

The actual internal stress and temperature when the battery is being charged are associated with the spectral signal, as shown in FIG. 7, there are a phantom model and a fiber core model in the spectral signal graph, and the changes in the temperature and actual internal stress when the battery is being charged will cause wavelength drift of the phantom model and the fiber core model in the spectral signal; the response sensitivity coefficients of the phantom model and the fiber core model to the temperature and the actual internal stress are different. Therefore, the wavelength changes of the phantom model and the fiber core model are respectively measured when the battery is being charged, a stress analysis matrix is established, and thus the temperature and actual internal stress when the battery is being charged can be directly decoupled. The specific stress analysis matrix is described as follows and will not listed here.

After obtaining the actual internal stress when the battery is being charged, the second spectral envelope area corresponding to the internal stress of the battery can be obtained according to the mapping relationship between the internal stress of the battery and the envelope area of the spectral signal under the internal stress.

The mapping relationship can be obtained before the battery charging process, and the specific obtaining method is described as follows and will not be listed here.

Therefore, by obtaining the mapping relationship between the internal stress and the envelope area when the battery is being charged, the second spectral envelope area corresponding to the internal stress when the battery is being charged can be quickly obtained, and thus the interference of the internal stress on the lithium plating detection result during the charging process can be reduced.

In some embodiments, the step of obtaining the actual internal stress when the battery is being charged includes: obtaining the wavelength variation of the first spectral signal; and obtaining the actual internal stress when the battery is being charged based on the wavelength variation in the first spectral signal and the stress analysis matrix of the battery.

As described above, when the battery is being charged, the changes in temperature and actual internal stress can both cause the wavelength shifts of the phantom model and core model in the spectral signal; moreover, the phantom model and core model have different sensitivity coefficients to temperature and actual internal stress, denoted as *K_{core,F}*, *K_{core,T}*, *K_{ghost,F}*, and *K_{ghost,T}*, respectively. Therefore, it is necessary to obtain the wavelength changes of the phantom model and core model in the first spectral signal; and after being obtained, the wavelength changes of the phantom model and core model are inputted into the stress analysis matrix so as to obtain the actual internal stress when the battery is being charged.

The stress analysis matrix is shown as follows: $\left[\begin{matrix}{Δλ}_{core} \\ {Δλ}_{ghost}\end{matrix}\right] = \left[\begin{matrix}{K}_{core , F} & {K}_{core , T} \\ {K}_{ghost , F} & {K}_{ghost , T}\end{matrix}\right] \left[\begin{matrix}F \\ T\end{matrix}\right]$

In which, *Δλ_{core}* refers to the wavelength variation of the core model, *Δλ_{ghost}* refers to the wavelength variation of the phantom model, *K*_{*core*,*F*} refers to the sensitivity coefficient of the core model to stress, *K*_{*core*,*T*} refers to the sensitivity coefficient of the core model to temperature, *K*_{*ghost*,*F*} refers to the sensitivity coefficient of the phantom model to stress, *K*_{*ghost*,*T*} refers to the sensitivity coefficient of the phantom model to temperature, F refers to stress, and T refers to temperature.

The four response sensitivity coefficients *K*_{*core*,*F*}, *K*_{*core*,*T*}, *K*_{*ghost*,*F*}, and *K*_{*ghost*,*T*} can be obtained through experiments, and in other embodiments, other methods can also be used. That is, during obtaining the actual internal stress when the battery is being charged, the above four response sensitivity coefficients are known. In this embodiment, it is only necessary to obtain the wavelength changes of the phantom model and core model in the spectral signal and input them into the stress analysis matrix for decoupling, and then the actual internal stress and temperature when the battery is being charged can be obtained.

Therefore, the actual internal stress when the battery is being charged can be quickly obtained based on the wavelength variation of the first spectral signal and the stress analysis matrix corresponding to the battery, thereby improving the efficiency of detecting the lithium plating of the battery.

In some embodiments, before obtaining the actual internal stress when the battery is being charged, the lithium plating detection method for a battery also includes: charging the battery at a preset rate, and obtaining a second optical signal when the battery is being charged at the preset rate; obtaining the second spectral signal corresponding to the second optical signal, and recording the wavelength variation in the second spectral signal and the envelope area variation in the cladding region; obtaining stress data of the battery based on the wavelength variation in the second spectral signal and a stress analysis matrix of the battery; fitting based on the stress data and the envelope area variation to obtain the mapping relationship.

As described above, during obtaining the second spectral envelope area corresponding to the internal stress based on the stress, it is necessary to obtain the mapping relationship between the internal stress and the envelope area when the battery is being charged, and the process of obtaining the mapping relationship includes that:
firstly, the battery is charged at a preset rate, the preset rate can be set to be less than a normal charging rate, and at the moment, the second spectral signal of the battery when being charged at the preset rate, and the variation of the fiber core model and the phantom mode in the second spectral signal as well as the envelope area variation of the cladding region are recorded.

At the moment, the variation of the fiber core model and the phantom mode can be decoupled by the stress analysis matrix described above to obtain the stress data of the battery; and finally, fitting is performed based on the stress data and the envelope area variation to obtain the mapping relationship.

Therefore, before the battery is subjected to charging lithium plating detection, the battery can be charged at the preset rate to obtain the mapping relationship between the internal stress and the envelope area of different batteries, thereby improving the accuracy of the battery lithium plating detection result.

In some embodiments, the step of determining the lithium plating detection result of the battery based on the first spectral envelope area includes: in response to the first spectral envelope area being greater than or equal to a corresponding first preset envelope area threshold, determining that the battery is subjected to lithium plating; and in response to the first spectral envelope area being less than a corresponding first preset envelope area threshold and greater than or equal to a corresponding second preset envelope area threshold, determining that the battery has a lithium plating risk, in which, the second preset envelope area threshold is less than the first preset envelope area threshold.

With reference to FIG. 11, FIG. 11 is a curve diagram of a lithium plating determination solution according to an Embodiment 1 of the present application. When the battery is being charged, it is needed to obtain the first envelope area corresponding to lithium plating in each state of charge when the battery is being charged and compare it with the corresponding first preset envelope area threshold and the second preset envelope area threshold; shown as a curve a in FIG. 11, and in response to that the first spectral envelope area is less than the corresponding second preset envelope area threshold in a certain state of charge, it is determined that the battery has no lithium plating risk in the state of charge; shown as a curve b in FIG. 11, in response to that the first spectral envelope area is less than the corresponding first preset envelope area threshold and greater than or equal to the corresponding second preset envelope area threshold in a certain state of charge, it is determined that the battery has a lithium plating risk in the state of charge; and shown as a curve c in FIG. 11, in response to that the first spectral envelope area is greater than or equal to the corresponding first preset envelope area threshold in a certain state of charge, it is determined that the battery is subjected to lithium plating in the state of charge.

Therefore, the first spectral envelope area, the first preset envelope area threshold, and the second preset envelope area threshold corresponding to the lithium plating are compared, and whether the battery is subjected to lithium plating or has a lithium plating risk can be quickly determined, so that the lithium plating condition in the battery can be detected in real time, and the risk of safety problems caused by lithium plating in the battery is reduced.

In some embodiments, the step of determining the lithium plating detection result of the battery based on the first spectral envelope area includes: normalizing the first spectral envelope area; in response to the normalized first spectral envelope area being greater than or equal to the corresponding first preset percentage threshold, determining that the battery is subjected to lithium plating; and in response to the normalized first spectral envelope area being less than the corresponding first preset percentage threshold and greater than or equal to the corresponding second preset percentage threshold, determining that the battery has the lithium plating risk, in which, the second preset percentage threshold is less than the first preset percentage threshold.

As described above, when the battery is being charged, it is needed to obtain the first envelope area corresponding to lithium plating under each state of charge in the battery and compared it with the corresponding first preset envelope area threshold and the second preset envelope area threshold so as to perform lithium plating judgment, but deviation of the thresholds will be caused due to the consistency of processing and manufacturing of TFBG sensors so that it is hard to give a unified and applicable threshold for different TFBG sensors. As for the problem, it is needed to normalize the first envelope area corresponding to lithium plating under each state of charge of the battery charging process, i.e. the first envelope area S₀ corresponding to lithium plating when the state of charge of the battery is 0 is obtained. S_{N} is continuously calculated after charging of the battery is started, and it is defined as W=S_{N}/S₀*100%, and W is compared with the W threshold so that whether lithium plating occurs can be determined. The W threshold is the first preset percentage threshold and the second preset percentage threshold.

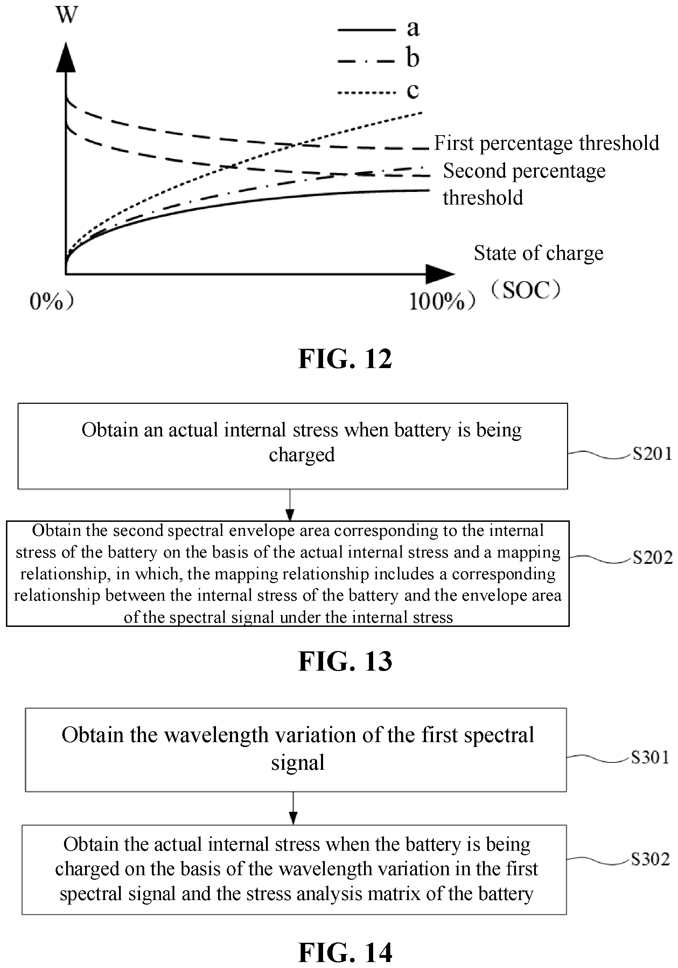

With reference to FIG. 12, FIG. 12 is a curve diagram of a lithium plating determination solution according to an Embodiment 2 of the present application. Shown as a curve a in FIG. 12, in response to that the first spectral envelope area after normalization in a certain state of charge is less than the corresponding second preset percentage threshold, it is determined that the battery has no lithium plating risk in the state of charge; shown as a curve b in FIG. 12, in response to that the first spectral envelope area after normalization in a certain state of charge is less than the corresponding first preset percentage threshold and greater than or equal to the corresponding second preset percentage threshold, it is determined that the battery has a lithium plating risk in the state of charge; and shown as a curve c in FIG. 12, in response to that the first spectral envelope area after normalization in a certain state of charge is greater than or equal to the corresponding first preset percentage threshold, it is determined that the battery is subjected to lithium plating in the state of charge.

Therefore, by normalizing the first spectral envelope area, the problem that it is hard to give a unified lithium plating determination threshold due to the difference of different fiber-optic sensors can be solved.

In some embodiments, after the step of determining the lithium plating detection result of the battery based on the first spectral envelope area, the lithium plating detection method for a battery further includes: in response to the battery being subjected to lithium plating or having the lithium plating risk when being charged, adjusting a charging strategy for the battery.

If the lithium plating detection result of the battery shows that the battery is subjected to lithium plating or has the lithium plating risk, it is represented that the battery is likely to be subjected to lithium plating or is about to be subjected to lithium plating, lithium plating can degrade the performance of the battery, and further dendritic lithium can puncture a spacer to cause a short circuit in the battery, resulting in a safety accident. After the above situation occurs, it is needed to adjust charging strategy so that the harm of lithium plating can be effectively avoided or reduced. The method for adjusting the charging strategy is described as follows and will not be listed here.

Therefore, if the battery is subjected to lithium plating or has the lithium plating risk when being charged, the charging strategy for the battery is adjusted to reduce the possibility of safety problems of the battery.

In some embodiments, the step of adjusting the charging strategy for the battery includes: in response to the lithium plating detection result showing the lithium plating risk, reducing a charging current of the battery to charge the battery until the lithium plating detection result of the battery shows no lithium plating risk; and in response to the lithium plating detection result showing the occurrence of lithium plating, stopping charging the battery and performing reverse discharging on the battery, and reducing the charging current of the battery when the battery is charged after reverse discharging.

During adjusting the charging strategy for the battery, based on the results of the three lithium plating detections, there are three corresponding strategies. 1, if there is clearly no lithium plating risk, the charging strategy does not need to be changed; 2, if the lithium plating detection results indicate the lithium plating risk at one or more states of charge, the current charging current is reduced by 5% and charging is continued until the warning of lithium plating risk no longer appears; if the lithium plating detection results indicate that the battery is subjected to lithium plating at one or more states of charge, charging the battery is charged, and the battery is discharged reversely, with a discharge current between 1-3C, and a discharge duration between 5-15s; and after the discharging ends, charging is carried out again, and at this time, the charging current is reduced by another 10%.

In other embodiments, the proportion of reducing the charging current, the size of the discharging circuit, the discharging duration and the size of the re-charging current can be set based on the actual situation of the battery, and no limitation is made at this time.

By way of example, if a battery with health degree of 90% is charged at a constant current with an initial current of 5C, and if the battery is charged to reach 50% of the state of charge, the signal obtained by the fiber-optic sensor indicates that the first preset envelope area threshold > the first spectral envelope area > the second preset envelope area threshold (or the first preset percentage threshold > the normalized first spectral envelope area > the second preset percentage threshold), it is determined that charging the battery at 5C from 50% of state of charge has the lithium plating risk; therefore, the subsequent charging current is reduced by 5% from the 50% of state of charge, that is, charging continues at 4.75C. If the battery continues to charge at 4.75C to reach 60% of state of charge and the signal obtained by the fiber-optic sensor indicates that the first preset envelope area threshold > the first spectral envelope area > the second preset envelope area threshold (or the first preset percentage threshold > the normalized first spectral envelope area > the second preset percentage threshold), it is determined that charging at 4.75C from a 60% state of charge has the lithium plating risk; and thus, the subsequent charging current is reduced by 5% from the 60% of state of charge, that is, charging continues at 4.5C; the subsequent charging process proceeds in the same manner.

By way of example, if a battery is charged at a constant current with an initial current of 4C, and if the battery is charged to reach 30% of the state of charge, the signal obtained by the fiber-optic sensor indicates that the first preset envelope area threshold > the first spectral envelope area > the second preset envelope area threshold (or the first preset percentage threshold > the normalized first spectral envelope area > the second preset percentage threshold), it is determined that charging the battery at 4C from 30% of state of charge has the lithium plating risk; therefore, the subsequent charging current is reduced by 5% from the 30% of state of charge, that is, charging continues at 3.8C. If the battery continues to charge at 3.8C to reach 32% of state of charge and the signal obtained by the fiber-optic sensor indicates that the first spectral envelope area threshold > the first preset envelope area threshold (or the normalized first spectral envelope area > the first preset percentage threshold), it is determined that charging at 32% state of charge has the lithium plating risk; charging is then stopped, and the battery is discharged at 2.5C for 10 sec. After discharging is completed, charging continues, and the charging current is further reduced by 10% based on 3.8C, meaning charging continues at 3.4C.

Therefore, when the battery is being charged, and the lithium plating detection result of the battery shows the lithium plating risk or the occurrence of lithium plating, the possibility of the safety problem of the battery in subsequent charging process can be reduced by reducing the charging current or stopping charging the battery and performing reverse charging, moreover, the charging speed can be increased to the maximum extent, thus avoiding lithium plating in the subsequent charging process, eliminating lithium partially plated from the battery, reducing the lithium plating harm.

With reference to FIG. 10, the lithium plating detection method for a battery based on the fiber-optic sensor provided by the present application specifically includes the following steps: S101 to S105:
Step S101: obtain the first optical signal outputted by the fiber-optic sensor when the battery is being charged.

The first optical signal outputted by the optical fiber sensor arranged on the battery is obtained by the control module during the charging process.

Step S102: Obtain the first spectral signal corresponding to the first optical signal, and obtain the total envelope area of the cladding region of the first spectral signal when the battery is being charged based on the first spectral signal.

As described above, the cladding region of the spectral signal is quite sensitive to changes in the ion concentration in the electrolyte solution inside the battery. If the negative electrode of the battery is charged to a certain state of charge, the ion concentration on its surface is closely related to lithium plating; and if the ion concentration exceeds a certain value, lithium plating begins on the surface of the negative electrode; therefore, the change of the area of the cladding region of the spectral signal can be monitored to realize real-time lithium plating detection.

Therefore, it is needed to obtain the total cladding region of the cladding region of the first spectral signal when the battery is being charged, and the total cladding region is the cladding region enclosed by upper and lower cladding lines of the cladding region.

Step S103: obtain the second spectral envelope area corresponding to the internal stress when the battery is being charged.

Besides being influenced by the ion concentration, the cladding region is also interfered by the internal stress of the battery, so that after obtaining the total cladding region enclosed by the upper and lower cladding lines of the cladding region of the spectral signal, it is also needed to obtain the second spectral cladding region corresponding to the internal stress when the battery is being charged. The method for obtaining the second spectral cladding region is shown as follows.

Step S104: calculate the difference value between the total envelope area and the second spectral envelope area so as to obtain the first spectral envelope area.

By calculating the difference value between the total cladding region and the second spectral cladding region, the change in the cladding region caused by the stress can be removed from the total cladding region of working condition charging to acquire the first spectral cladding region corresponding to lithium plating.

Step S105: determine the lithium plating detection result of the battery based on the first spectral envelope area.

After obtaining the first spectral cladding region corresponding to lithium plating of the battery, the first spectral cladding region is compared with the spectral cladding region to determine the lithium plating detection result of the battery.

Optionally, with reference to FIG. 13, FIG. 13 is a flow schematic diagram of step S103 according to an Embodiment 1 in FIG. 10. Step S103 can be realized through the method shown in FIG. 13, and the specific implementation steps include steps S201 to S202:
step S201: Obtain an actual internal stress when the battery is being charged.

The control module can calculate the actual internal stress when the battery is being charged based on the first spectral signal. The specific calculation mode is shown as follows.

Specifically, with reference to FIG. 14, FIG. 14 is a flow schematic diagram of step S201 according to an Embodiment 1 in FIG. 13. Step S201 can be realized through the method shown in FIG. 14, and the specific implementation steps include steps S301 to S302:
step S301: Obtain the wavelength variation of the first spectral signal.

As shown in FIG. 7, there are the phantom mode and the fiber core model in the spectral signal diagram, and the change in the temperature and the actual internal stress when the battery is being charged will cause wavelength drift of the phantom mode and the fiber core model in the spectral signal. During obtaining the actual internal stress, it is needed to obtain the wavelength variation of the phantom mode and the fiber core model in the first spectral signal firstly.

Step S302: Obtain the actual internal stress when the battery is being charged based on the wavelength variation in the first spectral signal and the stress analysis matrix of the battery.

After the wavelength variation of the phantom mode and the fiber core model in the first spectral signal is acquired, the wavelength variation of the phantom mode and the fiber core model can be substituted into the stress analysis matrix for decoupling so as to acquire the actual internal stress when the battery is being charged.

The stress analysis matrix is as described in the specification, and the stress analysis matrix represents the mapping relationship between the wavelength variation of the phantom mode and the fiber core model and the actual internal stress of the battery and the temperature.

Step S202: Obtain the second spectral envelope area corresponding to the internal stress of the battery based on the actual internal stress and a mapping relationship, in which, the mapping relationship includes a corresponding relationship between the internal stress of the battery and the envelope area of the spectral signal under the internal stress.

After obtaining the actual internal stress generated when the battery is being charged, the second spectral envelope area can be calculated based on the mapping relationship between the actual internal stress and the envelope area of the spectral signal under the internal stress,

The mapping relationship between the internal stress of the battery and the envelope area of the spectral signal under the internal stress can be obtained through a test.

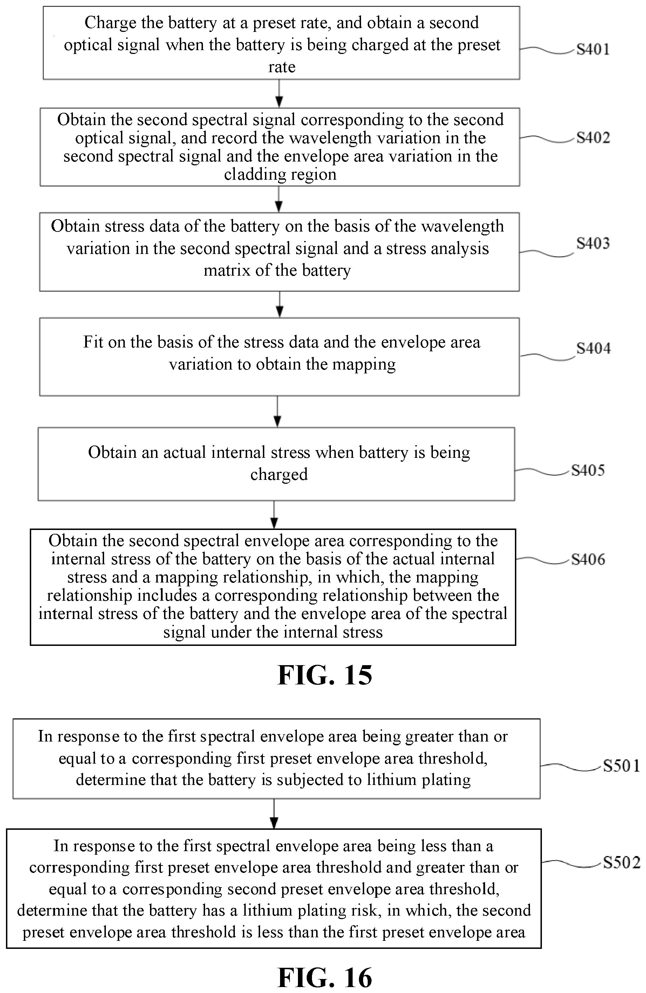

In some embodiments, with reference to FIG. 15, FIG. 15 is a flow schematic diagram of step S103 according to an Embodiment 2 in FIG. 10. Step S103 can be realized through the method shown in FIG. 15, and the specific implementation steps include steps S401 to S406:
step S401: Charge the battery at a preset rate, and obtain a second optical signal when the battery is being charged at the preset rate.

Before obtaining the mapping relationship between the internal stress and the second spectral envelope area corresponding to the internal stress based on the stress, it is needed to obtain the mapping relationship between the internal stress and the envelope area when the battery is being charged through a test or simulation.

In this embodiment, before the battery is normally charged, the battery can be charged at a preset rate to obtain a second optical signal when the battery is being charged at the preset rate. The preset rate can be set to be less than the normal charging rate.

Step S402: Obtain the second spectral signal corresponding to the second optical signal, and record the wavelength variation in the second spectral signal and the envelope area variation in the cladding region.

In the processing of charging at a preset rate, the second optical signal of the optical fiber sensor arranged on the battery can be obtained, the second optical signal is demodulated to obtain the corresponding second spectral signal, and at the moment, the variation of the fiber core model and the phantom mode in the second spectral signal is recorded; and the variation of the envelope area of the envelope region of the second spectral signal is recorded.

Step S403: Obtain stress data of the battery based on the wavelength variation in the second spectral signal and a stress analysis matrix of the battery.

After the variation of the fiber core model and the phantom mode in the second spectral signal is obtained, the variation of the fiber core model and the phantom mode in the second spectral signal can be substituted into the stress analysis matrix for decoupling based on the stress analysis matrix in the previous step, so that the stress data of the battery corresponding to the second spectral signal can be obtained.

Step S404: fit based on the stress data and the envelope area variation to obtain the mapping relationship.

The mapping relationship of the second spectral envelope area corresponding to internal stress can be obtained by fitting the corresponding stress data of the battery and the variation of the envelope area of the envelope region of the second spectral signal.

Step S405: Obtain an actual internal stress when the battery is being charged.

Step S405 is consistent with step S201 and is not repeated.

Step S406: Obtain the second spectral envelope area corresponding to the internal stress of the battery based on the actual internal stress and a mapping relationship, in which, the mapping relationship includes a corresponding relationship between the internal stress of the battery and the envelope area of the spectral signal under the internal stress.

Step S406 is consistent with step S202 and is not repeated.

In some embodiments, with reference to FIG. 16, FIG. 16 is a flow schematic diagram of step S105 according to an Embodiment 1 in FIG. 10. Step S105 can be realized through the method shown in FIG. 16, and the specific implementation steps include steps S501 to S502:
step S501: in response to the first spectral envelope area being greater than or equal to a corresponding first preset envelope area threshold, determine that the battery is subjected to lithium plating.

After obtaining the first spectral envelope area corresponding to battery lithium plating in each state of charge when the battery is being charged, the control module compares the first spectral envelope area in each state of charge with the corresponding first preset envelope area threshold and second preset envelope area threshold (the first preset envelope area threshold is greater than the second preset envelope area threshold), and determines that the battery is subjected to lithium plating in response to the first spectral envelope area being greater than or equal to the corresponding first preset envelope area threshold.

Step S502: in response to the first spectral envelope area being less than a corresponding first preset envelope area threshold and greater than or equal to a corresponding second preset envelope area threshold, determine that the battery has a lithium plating risk, in which, the second preset envelope area threshold is less than the first preset envelope area threshold.

After acquiring the first spectral envelope area corresponding to battery lithium plating in each state of charge when the battery is being charged, the control module compares the first spectral envelope area in each state of charge with the corresponding first preset envelope area threshold and second preset envelope area threshold (the first preset envelope area threshold is greater than the second preset envelope area threshold), and determines that the battery has a lithium plating risk in response to the first spectral envelope area being less than the corresponding first preset envelope area threshold and greater than or equal to the corresponding second preset envelope area threshold.

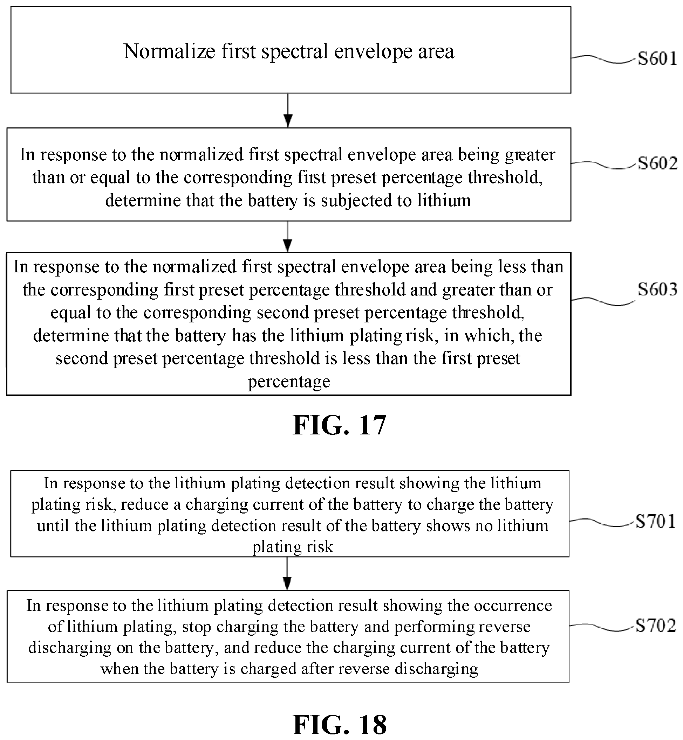

In some embodiments, with reference to FIG. 17, FIG. 17 is a flow schematic diagram of step S105 according to an Embodiment 2 in FIG. 10. Step S105 can be realized through the method shown in FIG. 17, and the specific implementation steps include steps S601 to S603:
step S601: normalize the first spectral envelope area.

Due to the consistency of processing and manufacturing of the optical fiber sensor, deviation of the threshold value will be caused, making it is hard to give the unified and applicable threshold value for different optical fiber sensors. In view of the problem, it is needed to normalize the first envelope area corresponding to lithium plating in each state of charge when the battery is being charged.

In the embodiments, the first envelope area S₀ corresponding to lithium plating under the state of charge of the battery is 0 is obtained. S_{N} is continuously calculated after the battery starts to be charged, and it is defined as W=S_{N}/S₀*100%.

In other embodiments, normalization can also be performed on the first spectral envelope area by adopting other modes, and no limitation is made here.

Step S602: in response to the normalized first spectral envelope area being greater than or equal to the corresponding first preset percentage threshold, determine that the battery is subjected to lithium plating.

The control module compares the normalized first spectral envelope area W with the first preset percentage threshold value and the second preset percentage threshold value (the first preset percentage threshold value is greater than the second preset percentage threshold value), and it is determined that the battery is subjected to lithium plating in response to the normalized first spectral envelope area W being greater than or equal to the corresponding first preset percentage threshold value.

Step S603: in response to the normalized first spectral envelope area being less than the corresponding first preset percentage threshold and greater than or equal to the corresponding second preset percentage threshold, determine that the battery has the lithium plating risk, in which, the second preset percentage threshold is less than the first preset percentage threshold.

The control module determines that the battery has the lithium plating risk in response to the normalized first spectral envelope area W being less than the corresponding first preset percentage threshold and greater than or equal to the corresponding second preset percentage threshold.

In some embodiments, the lithium plating detection method for a battery based on the fiber-optic sensor provided by the present application further includes the following step:
in response to the battery being subjected to lithium plating or having the lithium plating risk when being charged, adjusting a charging strategy for the battery.

If the battery is subjected to lithium plating or has the lithium plating risk when being charged, the charging strategy for the battery can be adjusted to reduce the possibility of safety problems of the battery.

Optionally, with reference to FIG. 18, FIG. 18 is a flow schematic diagram of charging strategy adjustment according to an embodiment of the present application. As shown in FIG. 18, the specific implementation steps in the embodiment include steps S701 to S702:
step S701: in response to the lithium plating detection result showing the lithium plating risk, reduce a charging current of the battery to charge the battery until the lithium plating detection result of the battery shows no lithium plating risk.

Specifically, if the lithium plating detection result of the battery is that the battery has the lithium plating risk in a certain state of charge or a plurality of states of charge, 5% of the current charging current is reduced to continue charging until no alarm is given for the lithium plating risk.

Step S702: in response to the lithium plating detection result showing the occurrence of lithium plating, stop charging the battery and performing reverse discharging on the battery, and reduce the charging current of the battery when the battery is charged after reverse discharging.

Specifically, if lithium plating detection results shows all lithium plating in a certain state of charge or multiple states of charge, the battery is stopped charging and discharged reversely, the discharge current is between 1-3C, the discharge duration is between 5-15s, charging is continued after the discharge is finished, and the magnitude of the charging current is reduced by 10% again at the moment.

In other embodiments, the proportion of reducing the charging current, the size of the discharging circuit, the discharging duration and the size of the re-charging current can be set based on the actual situation of the battery, and no limitation is made at this time.

Different from the existing technology, the lithium plating detection method for a battery provided by the present application has the advantages that by means of analyzing the spectral signal, the interference of the internal stress of the battery on lithium plating detection can be reduced, the first spectral envelope area corresponding to lithium plating when the battery is being charged can be quickly obtained, and the lithium plating condition in the battery can be confirmed, thus the harm of lithium plating in the battery can be effectively reduced, and the safety accidents caused by battery lithium plating can be reduced.

The above description of various embodiments tends to emphasize the differences between each embodiment, and their similarities or common features can be cross-referenced. For the sake of brevity, they will not be repeated here.

In the several embodiments provided in the present disclosure, it is to be understood that the disclosed method and apparatus can be implemented in other manners. For example, the apparatus embodiments described above are merely exemplary. For example, the division of the modules or units is merely the division of logic functions, and may use other division manners during actual implementation. For example, units or components may be combined, or may be integrated into another system, or some features may be omitted or not performed. In addition, the displayed or discussed mutual couplings or direct couplings or communication connections may be implemented through some interfaces. The indirect couplings or communication connections between the apparatuses or units may be implemented in electronic, mechanical, or other forms.

In addition, functional units in the embodiments of this application may be integrated into one processing unit, or each of the units may be physically separated, or two or more units may be integrated into one unit. The integrated unit may be implemented in the form of hardware, or may be implemented in a form of a software functional unit. When the integrated unit is implemented in a form of a software functional unit and sold or used as an independent product, the integrated unit may be stored in one computer readable storage medium. Based on such an understanding, the technical solutions of this application essentially, or a part contributing to the related art, or all or a part of the technical solution may be implemented in a form of a software product. The computer software product is stored in a storage medium and includes several instructions for instructing one computer device (which may be a PC, a server, a network device or the like) or a processor to perform all or some of steps of the methods in the embodiments of this application. The storage medium includes a USB flash disk, a mobile hard disk, a Read-Only Memory (ROM), a Random Access Memory (RAM), a disk or an optical disk and other media capable of storing program codes.

## Claims

1. A lithium plating detection method for a battery based on a fiber-optic sensor, a detection part of the fiber-optic sensor being arranged in the battery, the lithium plating detection method comprising:
obtaining a first optical signal outputted by the fiber-optic sensor when the battery is being charged;
obtaining a first spectral signal corresponding to the first optical signal, and obtaining a total envelope area of a cladding region of the first spectral signal when the battery is being charged based on the first spectral signal;
obtaining a second spectral envelope area corresponding to an internal stress when the battery is being charged;
calculating a difference between the total envelope area and the second spectral envelope area, so as to obtain a first spectral envelope area; and
determining a lithium plating detection result for the battery based on the first spectral envelope area.

2. The lithium plating detection method for a battery according to claim 1, wherein the step of obtaining the second spectral envelope area corresponding to the internal stress when the battery is being charged comprises:
obtaining an actual internal stress when the battery is being charged; and
obtaining the second spectral envelope area corresponding to the internal stress of the battery based on the actual internal stress and a mapping relationship;
in which, the mapping relationship comprises a corresponding relationship between the internal stress of the battery and the envelope area of the spectral signal under the internal stress.

3. The lithium plating detection method for a battery according to claim 2, wherein before obtaining the actual internal stress when the battery is being charged, the lithium plating detection method for a battery also comprises:
charging the battery at a preset rate, and obtaining a second optical signal when the battery is being charged at the preset rate;
obtaining the second spectral signal corresponding to the second optical signal, and recording the wavelength variation in the second spectral signal and the envelope area variation in the cladding region;
obtaining stress data of the battery based on the wavelength variation in the second spectral signal and a stress analysis matrix of the battery; and
fitting based on the stress data and the envelope area variation to obtain the mapping relationship.

4. The lithium plating detection method for a battery according to claim 2 or 3, wherein the step of obtaining the actual internal stress when the battery is being charged comprises:
obtaining the wavelength variation of the first spectral signal; and
obtaining the actual internal stress when the battery is being charged based on the wavelength variation in the first spectral signal and the stress analysis matrix of the battery.

5. The lithium plating detection method for a battery according to any one of claims 1 to 4, wherein the step of determining the lithium plating detection result of the battery based on the first spectral envelope area comprises:
in response to the first spectral envelope area being greater than or equal to a corresponding first preset envelope area threshold, determining that the battery is subjected to lithium plating; and
in response to the first spectral envelope area being less than a corresponding first preset envelope area threshold and greater than or equal to a corresponding second preset envelope area threshold, determining that the battery has a lithium plating risk, in which, the second preset envelope area threshold is less than the first preset envelope area threshold.

6. The lithium plating detection method for a battery according to any one of claims 1 to 4, wherein the step of determining the lithium plating detection result of the battery based on the first spectral envelope area comprises:
normalizing the first spectral envelope area;
in response to the normalized first spectral envelope area being greater than or equal to the corresponding first preset percentage threshold, determining that the battery is subjected to lithium plating; and
in response to the normalized first spectral envelope area being less than the corresponding first preset percentage threshold and greater than or equal to the corresponding second preset percentage threshold, determining that the battery has the lithium plating risk, in which, the second preset percentage threshold is less than the first preset percentage threshold.

7. The lithium plating detection method for a battery according to claim 5 or 6, wherein after the step of determining the lithium plating detection result of the battery based on the first spectral envelope area, the lithium plating detection method for a battery further comprises:
in response to the battery being subjected to lithium plating or having the lithium plating risk when being charged, adjusting a charging strategy for the battery.

8. The lithium plating detection method for a battery according to claim 7, wherein the step of adjusting the charging strategy for the battery comprises:
in response to the lithium plating detection result showing the lithium plating risk, reducing a charging current of the battery to charge the battery until the lithium plating detection result of the battery shows no lithium plating risk; and
in response to the lithium plating detection result showing the occurrence of lithium plating, stopping charging the battery and performing reverse discharging on the battery, and reducing the charging current of the battery when the battery is charged after reverse discharging.

9. A battery, comprising a battery body, at least one fiber-optic sensor, and a control module, wherein the detection part of the fiber-optic sensor is arranged inside the battery body, the fiber-optic sensor is configured to output an optical signal when the battery is being charged, and the control module is connected to the fiber-optic sensor; the control module is configured to obtain the first spectral signal corresponding to the optical signal, and obtain the total envelope area of the cladding region of the first spectral signal when the battery is being charged based on the first spectral signal, obtain the second spectral envelope area corresponding to the internal stress when the battery is being charged, calculate the difference value between the total envelope area and the second spectral envelope area so as to obtain the first spectral envelope area, and determine the lithium plating detection result of the battery based on the first spectral envelope area.

10. The battery according to claim 9, wherein the fiber-optic sensor comprises at least one grating part and a transmission optical fiber connected to the grating part, and the grating part is arranged inside the battery body.

11. The battery according to claim 10, wherein an input end and an output end of the transmission optical fiber are both arranged outside the battery body, and a middle connecting part of the input end and the output end of the transmission optical fiber is arranged inside the battery body.

12. The battery according to claim 10, wherein a reflecting layer is arranged inside the battery body, the input end of the transmission optical fiber is arranged outside the battery body, and the output end of the transmission optical fiber is arranged inside the battery body and abuts against the reflecting layer, in which, the reflecting layer is configured to reflect the initial optical signal incident from the input end so as to transmit the output optical signal from the input end to the outside.

13. The battery according to claim 11, wherein the transmission optical fiber comprises a fiber core and a cladding layer, and the diameter of the cladding layer is set to be 25-125 µm.

14. The battery according to claim 11, wherein the transmission optical fiber comprises the fiber core and the cladding layer, and the diameter of the cladding is set to be 50-100 µm.

15. The battery according to claim 11, wherein the length of the grating part is set to be 0.3-1.2 cm.

16. The battery according to claim 11, wherein the length of the grating part is set to be 0.5-1 cm.

17. The battery according to any one of claims 9 to 16, wherein the control module comprises an optical demodulation module and a battery management module; the optical demodulation module is connected to the fiber-optic sensor and is configured to modulate the optical signal outputted by the fiber-optic sensor when the battery is being charged so as to obtain the first spectral signal; the battery management module is connected to the optical demodulation module and is configured to obtain the total envelope area of the cladding region of the first spectral signal when the battery is being charged based on the first spectral signal, obtain the second spectral envelope area corresponding to internal stress when the battery is being charged, calculate the difference value between the total envelope area and the second spectral envelope area so as to obtain the first spectral envelope area, and determine the lithium plating detection result of the battery based on the first spectral envelope area.

18. A battery system, comprising battery according to any one of claims 9 to 17 and a charge-discharge control module, wherein the charge-discharge control module is connected to the control module and the battery and is configured to, in response to the occurrence of lithium plating or the lithium plating risk when the battery is being charged, adjust the charging strategy for the battery.

19. An electrical apparatus, comprising the battery system according to claim 18.
